Europäisches Patentamt

European Patent Office

Office européen des brevets

(11) Publication number: **0 115 165**
**B1**

# EUROPEAN PATENT SPECIFICATION

(45) Date of publication of patent specification: **28.02.90**

(51) Int. Cl.⁵: **H 03 F 3/347, H 03 F 3/45**

(21) Application number: **83307789.4**

(22) Date of filing: **21.12.83**

(54) Active load circuit.

(30) Priority: **25.12.82 JP 233262/82**

(43) Date of publication of application:
**08.08.84 Bulletin 84/32**

(45) Publication of the grant of the patent:
**28.02.90 Bulletin 90/09**

(84) Designated Contracting States:
**DE FR GB**

(56) References cited:
**US-A-3 351 865**
**US-A-4 055 774**
**US-A-4 250 460**

**IEEE JOURNAL OF SOLID-STATE CIRCUITS, vol.
SC-15, no. 6, December 1980, pages 1059-1070,**

**IEEE, New York, US; B.E. AMAZEEN et al.: "A
complete single-supply microprocessor-
compatible 8-bit DAC"**

(73) Proprietor: **FUJITSU LIMITED**
**1015, Kamikodanaka Nakahara-ku
Kawasaki-shi Kanagawa 211 (JP)**

(72) Inventor: **Sano, Yoshiaki
4-3-6-103 Azamino Midori-ku
Yokohama-shi Kanagawa 227 (JP)**

(74) Representative: **Sunderland, James Harry et al
HASELTINE LAKE & CO Hazlitt House 28
Southampton Buildings Chancery Lane
London WC2A 1AT (GB)**

Courier Press, Leamington Spa, England.

## Description

The present invention relates to an active load circuit with improved operational stability, for example when used as an active load circuit for a differential current amplifier.

In a prior art circuit including a differential amplifier consisting of a pair of transistors, which receive a differential input, and a constant current source, the circuit also includes an active load circuit (or bias circuit) consisting of first (A and B) and second (C and D) pairs of transistors and another constant current source.

The current output from the circuit is obtained by flowing constant currents through the active load circuit transistors A, B, C, and D and on into and through the transistors in the differential amplifier.

In the above-described active load circuit, transistors A and B act as a current mirror circuit to form an active load to the amplifier, while transistors C and D are emitter followers, i.e., their collectors are grounded, for the output stage.

A disadvantage of the above prior art circuit is that an offset current exists, and the circuit is balanced at a point shifted by this offset current. Another disadvantage is that a sufficiently high output current, i.e., a sufficiently large amplification factor, cannot be obtained, because of an insufficient change in the output current above the current differential.

In the above description, it is assumed that the amplification factors of transistors A, B, C, and D are all equal. However, the amplification factors in fact change, depending on the collector currents.

The amplification factor has a convex curve characteristic, i.e., any increase corresponds to an increase in the collector current, reaches a predetermined value, and then decreases. Thus, to make the amplification factors of transistors A, B, C, and D all equal, the operation current for these transistors must also be made equal. The amplification factors of transistors A and B can be made equal by regulating their collector currents. This collector current regulation is effected by adjusting the constant current source. The amplification factor of transistor D can also be made equal to those of transistors A and B by regulating D's collector current through adjustments to the other constant current source. However, the collector current of transistor C is small, as it is the sum of the base currents of transistors A and B, and it is difficult to adjust the amplification factor of transistor C to those of transistors A, B, and D, even if the characteristic of transistor C is equal to those of transistors A, B, and D.

As can be seen from the above description, the offset current in this prior art circuit will be greater than required, and thus the circuit will probably become more unbalanced.

According to one aspect of the present invention, there is provided an active load circuit comprising:

a first and a second transistors whose emitters are connected to a voltage source line;

a third transistor whose emitter is connected to the bases of the first and second transistors and whose base is connected to one of the collectors of the first and second transistors so as to cause equal collector currents of the first and second transistors to flow:

a fourth transistor whose base is connected to the other of the collectors of the first and second transistors;

a constant current source connected to the emitter of the fourth transistor;

first and second current control inputs, respectively connected to the collector electrodes of the first and second transistors; and

an output connected between the constant current source and the emitter of the fourth transistor; characterised in that:

the collector of the fourth transistor is connected to the emitter of the third transistor.

According to a second aspect of the present invention, there is provided an amplifier circuit comprising:

a first and a second transistors whose emitters are connected to a voltage source line;

a third transistor whose emitter is connected to the bases of the first and second transistors and whose base is connected to one of the collectors of the first and second transistors, so as to cause equal collector currents of the first and second transistors to flow;

a fourth transistor whose base is connected to the other of the collectors of the first and second transistors;

a first constant current source connected to the emitter of the fourth transistor;

a current control means having a first and a second current sources respectively connected to the collectors of the first and second transistors, the difference in currents of said first and second current sources being varied in response to an input signal; and

an output connected between the first constant current source and the emitter of the fourth transistor; characterised in that

the collector of the fourth transistor is connected to the emitter of the third transistor.

An embodiment of the present invention can thereby provide an active load circuit which can improve operational stability and increase the ratio of the output current to the input current, i.e. the gain, without increasing the circuit elements and with a simple structure.

Reference is made, by way of example, to the accompanying drawings, in which:

Fig. 1 is a diagram of a prior art active load circuit;

Fig. 2 is a diagram of an embodiment of an active load circuit according to the present invention; and

Fig. 3 is a diagram of another embodiment of an active load circuit according to the present invention.

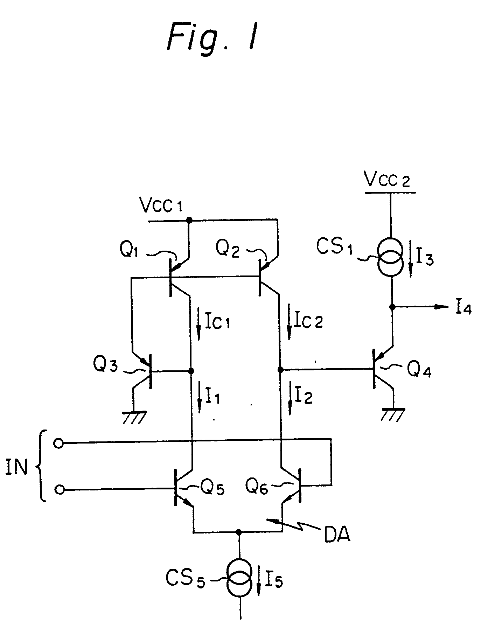

Before describing the preferred embodiments of the present invention, it is necessary to describe in detail an example of a prior art circuit with reference to Figure 1, to ensure a clearer understanding of the advantages of the present invention.

Figure 1 is a diagram of a prior art active load circuit. The circuit includes a differential amplifier DA consisting of a pair of transistors $Q_5$ and $Q_6$ which receive a differential input IN, and a constant current source $CS_5$. The circuit also includes an active load circuit (or bias circuit) consisting of transistors $Q_1$ to $Q_4$ and a constant current source $CS_1$. The circuit in Figure 1 provides an output current $I_4$ by applying the currents $I_1$ and $I_2$ which flow between the transistors $Q_5$ and $Q_6$ and the active load circuit. The transistors $Q_1$ to $Q_3$ form a current mirror circuit and act as an active load to the amplifier DA. The transistor $Q_4$ is an emitter follower for the output stage, i.e., its collector is grounded, as is a collector of the transistor $Q_3$.

If each current amplification factor of the pnp transistors $Q_1$ to $Q_4$ is $\beta$, the emitter current, $I_E$ of the pnp transistors $Q_1$ to $Q_4$, base currents $I_B$, and collector currents $I_C$ have the following relationships:

$$I_B = \frac{I_C}{\beta} = \frac{I_E}{1 + \beta}, \text{ and}$$

$$I_C = \beta I_B = \frac{\beta}{1 + \beta} I_E.$$

Therefore, the currents $I_1$ and $I_2$ flowing to transistors $Q_5$ and $Q_6$ are defined in the following equations (1) and (2):

$$I_1 = I_{C1} + (I_{C1} + I_{C2}) \frac{1}{(\beta + 1)\beta} \quad (1)$$

$$I_2 = I_{C2} + (I_3 - I_4) \frac{1}{\beta + 1} \quad (2)$$

In the above equations, $I_{C1}$ and $I_{C2}$ are collector currents of transistors $Q_1$ and $Q_2$ and are equal on the basis of the current mirror circuit principle, that is:

$$I_{C1} = I_{C2} = I_C.$$

Accordingly, the following equation (3) is derived from the above equations (1) and (2):

$$I_1 - I_2 = \frac{2}{\beta(\beta + 1)} I_C - \frac{1}{\beta + 1}(I_3 - I_4) \quad (3)$$

As can be clearly understood from equation (3), the output current $I_4$ does not equal the current $I_3$ of the current source $CS_1$ even if $I_1 = I_2$, i.e., the differential input IN is zero.

In addition, the following equation (4) is derived from equation (3) when $I_1$ equals $I_2$:

$$I_4 = I_3 - \frac{2}{\beta} I_C \quad (4)$$

In this circuit, an offset current in the equation (4) exists, in other words, the circuit is balanced at a point shifted by the offset current. This is a disadvantage of the above circuit.

Another disadvantage of the circuit is that a large output current $I_4$ cannot be obtained, i.e., a sufficient amplification factor cannot be obtained, because the change of the output current $I_4$ becomes only about $\beta$ times the current difference $(I_1 - I_2)$; normally $\beta$ is several tens.

In the above description, it is assumed that the amplification factor $\beta$ of all of the transistors $Q_1$ to $Q_4$ is equal, however, in actual practice, the amplification factor varies, depending on the collector current. The amplification factor $\beta$ has a convex curve characteristic, i.e., any increase in the amplification factor corresponds to an increase in the collector current, reaches a predetermined maximum value, and then decreases. Therefore, in order to make all of the transistors' amplification factors equal, the operation currents of each pair of the transistors must also be made equal. The amplification factors of transistors $Q_1$ and $Q_2$ can be made equal by regulating their collector currents. This collector current regulation is effected by adjusting the constant current source $CS_5$. The amplification factor of the transistor $Q_4$ can also be made equal to those of the transistors $Q_1$ and $Q_2$, by regulating the collector current for $Q_4$ by adjusting the constant current source $CS_1$. On the other hand, the collector current of the transistor $Q_3$ is small, as it is the sum of the base currents of the transistors $Q_1$ and $Q_2$. Thus, it is difficult to adjust the amplification factor $\beta$ of the transistor $Q_3$ to those of the transistors $Q_1$, $Q_2$, and $Q_4$, even if the characteristic of the transistor $Q_3$ is equal to those of transistors $Q_1$, $Q_2$, and $Q_4$. This means the equation (3) cannot be realized in actual practice. As can be seen from the above description, the actual offset current in this prior art circuit is greater than that shown by equation (3), and thus the circuit shown in Figure 1 will be more unbalanced.

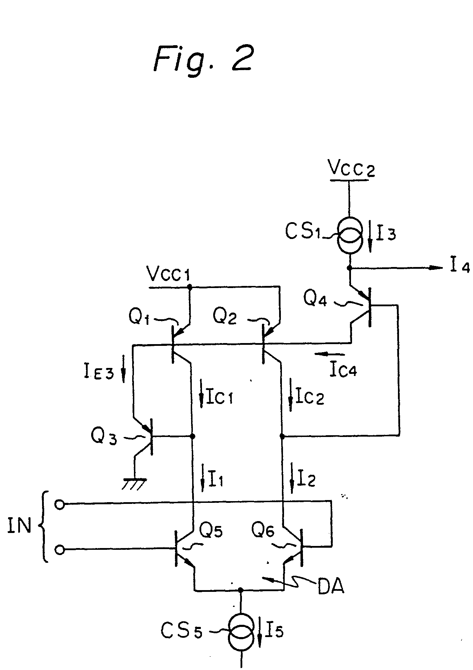

Figure 2 is a diagram of an embodiment of an active load circuit according to the present invention. In Figure 2, the transistors $Q_1$, $Q_2$, and $Q_3$ forming the current mirror circuit are the same as those shown in Figure 1. The transistors $Q_5$ and $Q_6$ and the constant current source $CS_5$ forming the differential amplifier circuit (DA) are also the same as those shown in Figure 1. The constant current source $CS_1$ is the same as that in Figure 1, and the transistor $Q_4$ is the same as that in Figure 1, with the exception that its collector is connected to the emitter of the transistor $Q_3$, instead of forming the emitter-follower circuit, i.e., grounding the collector of transistor $Q_4$.

According to the circuit connection shown in Figure 2, the collector current $I_{C4}$ of the transistor $Q_4$ flows to the emitter of the transistor $Q_3$,

whereby, the operation currents of the transistors $Q_3$ and $Q_4$ are made equal.

As mentioned previously in the description of a prior art circuit, the amplification factors $\beta$ of transistors $Q_1$ to $Q_4$ vary, depending on the collector currents. In order to make the amplification factors of transistors $Q_1$ to $Q_4$ equal, the operational collector current $I_{C1}$ must equal $I_{C2}$, and $I_{C3}$ must equal $I_{C4}$. The collector currents of transistors $Q_1$ and $Q_2$ are regulated by adjusting the constant current source $CS_5$.

The collector current $I_{C4}$ of transistor $Q_4$ is regulated by adjusting the constant current source $CS_1$. The value of the emitter current $I_{E3}$ of transistor $Q_3$ is approximately equal to the value of the collector current $I_{C4}$, in accordance with the connection shown in Figure 2. Therefore, the operation currents of $Q_1$ and $Q_2$, $Q_3$ and $Q_4$, can be made equal, i.e., all of the amplification factors $\beta$ of transistors $Q_1$ to $Q_4$ can be made equal.

Therefore, the following equations are defined:

$$I_{C4} = (I_3 - I_4)\frac{\beta}{\beta + 1} \qquad (5)$$

$$I_2 = I_{C2} + (I_3 - I_4)\frac{1}{\beta + 1} \qquad (6)$$

$$I_{E3} = I_{C4} + (I_{C1} + I_{C2})\frac{1}{\beta}\text{ and} \qquad (7)$$

$$I_1 = I_{C1} + I_{E3}\frac{1}{\beta + 1} \qquad (8)$$

Assuming the following relationship as mentioned in the prior art circuit:

$$I_{C1} = I_{C2} = I_C$$

and substituting this into the above equations (5) to (8), the following equation can be derived from equations (5), (7), and (8):

$$I_1 = \left\{1 + \frac{2}{(\beta + 1)\,\beta}\right\} I_C + \frac{\beta}{(\beta + 1)^2}(I_3 - I_4) \quad (9)$$

and a further equation can be derived from equation (6):

$$I_2 = I_C + \frac{1}{(\beta + 1)}(I_3 - I_4) \qquad (10)$$

Finally, the following equation corresponding to equation (3) of the prior art circuit can be obtained:

$$I_1 - I_2 = \frac{2}{(\beta + 1)\,\beta}\; I_C - \frac{1}{(\beta + 1)^2}(I_3 - I_4) \qquad (11)$$

Equation (11) in accordance with the present invention proves that the gain is increased to approximately the order of $\beta^2$. Considering the difference between the equations (11) and (3), the ratio of the output current $I_4$ to the differential inputs in accordance with the present invention is approximately $\beta$ times that in the prior art circuit shown in Figure 1.

In addition, the following equation (12) is derived from equation (11) when $I_1$ equals $I_2$:

$$I_4 = I_3 - (1 + \frac{1}{\beta})\, 2I_C \qquad (12)$$

Considering the difference between the equations (4) and (12), the offset term of the present invention is smaller by $2I_C$ than in the prior art circuit, whereby the operational stability of the circuit is increased.

The above embodiment with reference to Figure 2 is an example of an active load circuit for a differential amplifier circuit (DA). The present invention, however, can be applied to other embodiments.

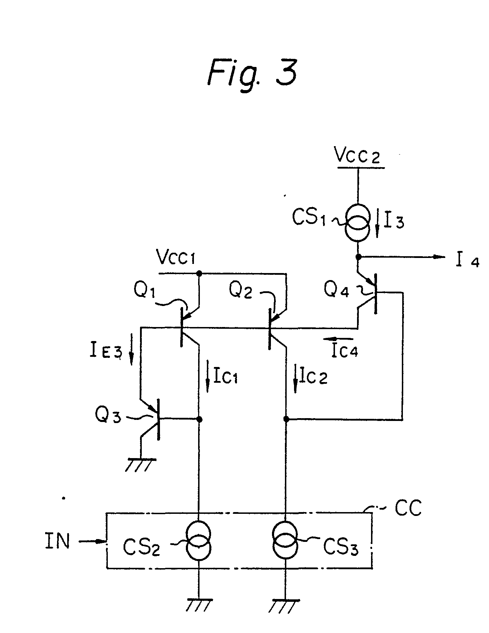

Figure 3 is a general circuit diagram in accordance with the present invention. The amplifier circuit shown in Figure 3 comprises current control means CC consisting of current sources $CS_2$ and $CS_3$, instead of the amplifier DA and the active load circuit mentioned above with reference to Figure 2. The difference current between the currents $CS_2$ and $CS_3$ is controlled by an input signal IN.

The amplifier circuit shown in Figure 3 provides a high amplification factor and high operational stability.

## Claims

1. An active load circuit comprising:
   first and second transistors ($Q_1$, $Q_2$) whose emitters are connected to a voltage source line ($V_{cc1}$);
   a third transistor ($Q_3$) whose emitter is connected to the bases of the first and second transistors ($Q_1$, $Q_2$) and whose base is connected to one of the collectors of the first and second transistors ($Q_1$, $Q_2$) so as to cause equal collector currents of the first and second transistors ($Q_1$, $Q_2$) to flow;
   a fourth transistor ($Q_4$) whose base is connected to the other of the collectors of the first and second transistors ($Q_1$, $Q_2$);
   a constant current source ($CS_1$) connected to the emitter of the fourth transistor ($Q_4$);
   first and second current control inputs, respectively connected to the collector electrodes of the first and second transistors ($Q_1$, $Q_2$); and
   an output connected to the junction of the

constant current source (CS$_1$) with the emitter of the fourth transistor (Q$_4$); characterized in that:

the collector of the fourth transistor (Q$_4$) is connected to the emitter of the third transistor (Q$_3$).

2. An amplifier circuit comprising:

first and second transistors (Q$_1$, Q$_2$) whose emitters are connected to a voltage source line (V$_{cc1}$);

a third transistor (Q$_3$) whose emitter is connected to the bases of the first and second transistors (Q$_1$, Q$_2$) and whose base is connected to one of the collectors of the first and second transistors (Q$_1$, Q$_2$), so as to cause equal collector currents of the first and second transistors (Q$_1$, Q$_2$) to flow;

a fourth transistor (Q$_4$) whose base is connected to the other of the collectors of the first and second transistors (Q$_1$, Q$_2$);

a first constant current source (CS$_1$) connected to the emitter of said fourth transistor (Q$_4$);

a current control means (DA; CC) having a first and a second current sources respectively connected to the collectors of the first and second transistors (Q$_1$, Q$_2$), the difference in currents of said first and second current sources being varied in response to an input signal (IN); and

an output connected to the junction of the first constant current source (CS$_1$) with the emitter of the fourth transistor (Q$_4$); characterised in that the collector of the fourth transistor (Q$_4$) is connected to the emitter of the third transistor (Q$_3$).

3. An amplifier circuit according to claim 2, wherein said first and second current sources are formed with a pair of transistors (Q$_5$, Q$_6$) whose bases receive a differential input signal (IN), and whose collectors are respectively connected to the first and second transistors (Q$_1$, Q$_2$), and a second constant current source (CS$_5$) to which emitters of said pair of transistors (Q$_5$, Q$_6$) are connected.

**Patentansprüche**

1. Aktive Lastschaltung mit:

ersten und zweiten Transistoren (Q$_1$, Q$_2$), deren Emitter mit einer Spannungsquellenleitung (V$_{cc1}$) verbunden sind;

einem dritten Transistor (Q$_3$), dessen Emitter mit den Basen der ersten und zweiten Transistoren (Q$_1$, Q$_2$) verbunden ist und dessen Basis mit einem der Kollektoren der ersten und zweiten Transistoren verbunden ist, um so gleiche Kollektorströme des ersten und zweiten Transistors (Q$_1$, Q$_2$) fließen zu machen;

einem vierten Transistor (Q$_4$), dessen Basis mit dem anderen der Kollektoren der ersten und zweiten Transistoren (Q$_1$, Q$_2$) verbunden ist;

einer Konstantstromquelle (CS$_1$), die mit dem Emitter des vierten Transistors (Q$_4$) verbunden ist;

ersten und zweiten Stromsteuereingängen, die jeweils mit den Kollektorelektroden der ersten und zweiten Transistoren (Q$_1$, Q$_2$) verbunden sind; und

einem Ausgang, der mit der Verbindung der Konstantstromquelle (CS$_1$) mit dem Emitter des vierten Transistors (Q$_4$) verbunden ist; dadurch gekennzeichnet, daß:

der Kollektor des vierten Transistors (Q$_4$) mit dem Emitter des dritten Transistors (Q$_3$) verbunden ist.

2. Verstärkerschaltung mit:

ersten und zweiten Transistoren (Q$_1$, Q$_2$), deren Emitter mit einer Spannungsquellenleitung (V$_{cc1}$) verbunden sind;

einem dritten Transistor (Q$_3$), dessen Emitter mit den Basen der ersten und zweiten Transistoren (Q$_1$, Q$_2$) verbunden ist und dessen Basis mit einem der Kollektoren der ersten und zweiten Transistoren (Q$_1$, Q$_2$) verbunden ist, um so gleiche Kollektorströme des ersten und des zweiten Transistors (Q$_1$, Q$_2$) fließen zu machen;

einem vierten Transistor (Q$_4$), dessen Basis mit dem anderen der Kollektoren der ersten und zweiten Transistoren (Q$_1$, Q$_2$) verbunden ist;

einer ersten Konstantstromquelle (CS$_1$), die mit dem Emitter des genannten vierten Transistors (Q$_4$) verbunden ist;

einer Stromsteuereinrichtung (DA; CC), die erste und zweite Stromquellen hat, die mit den Kollektoren des ersten bzw. zweiten Transistors (Q$_1$, Q$_2$) verbunden sind, wobei die Stromdifferenz der ersten und zweiten Stromquellen in Abhängigkeit von einem Eingangssignal (IN) variiert wird; und

einem Ausgang, der mit der Verbindung der ersten Konstantstromquelle (CS$_1$) mit dem Emitter des vierten Transistors (Q$_4$) verbunden ist, dadurch gekennzeichnet, daß

der Kollektor des vierten Transistors (Q$_4$) mit dem Emitter des dritten Transistors (Q$_3$) verbunden ist.

3. Verstärkerschaltung nach Anspruch 2, bei der die genannten ersten und zweiten Stromquellen mit einem Paar von Transistoren (Q$_5$, Q$_6$) gebildet sind, deren Basen ein Differenz-Eingangssignal (IN) empfangen, und deren Kollektoren mit den ersten bzw. zweiten Transistoren (Q$_1$, Q$_2$) verbunden sind, und einer zweiten Konstantstromquelle (CS$_5$), mit welcher die Emitter des Paares von Transistoren (Q$_5$, Q$_6$) verbunden sind.

**Revendications**

1. Circuit de charge active, comprenant:

un premier et un deuxième transistor (Q$_1$, Q$_2$) dont les émetteurs sont connectés à une ligne de source de tension (V$_{cc1}$);

un troisième transistor (Q$_3$) dont l'émetteur est connecté aux bases du premier et deuxième transistor (Q$_1$, Q$_2$) et dont la base est connectée à l'un des collecteurs desdits premier et deuxième transistor (Q$_1$, Q$_2$), de manière à provoquer le passage des courants de collecteur égaux des premier et deuxième transistor (Q$_1$, Q$_2$);

un quatrième transistor (Q$_4$) dont la base est connectée à l'autre des collecteurs desdits premier et deuxième transistor (Q$_1$, Q$_2$);

une source de courant constant (CS$_1$) connectée

à l'émetteur du quatrième transistor ($Q_4$);

une première et une deuxième entrée de commande de courant, respectivement connectées aux électrodes de collecteur du premier et deuxième transistor ($Q_1$, $Q_2$); et

une sortie connectée à la jonction de la source de courant constant ($CS_1$) à l'émetteur du quatrième transistor ($Q_4$); caractérise en ce que:

le collecteur du quatrième transistor ($Q_4$) est connecté à l'émetteur du troisième transistor ($Q_3$).

2. Circuit amplificateur comprenant un premier et un deuxième transistor ($Q_1$, $Q_2$) dont les émetteurs sont connectés à une ligne de source de tension ($V_{CC1}$);

un troisième transistor ($Q_3$) dont l'émetteur est connecté aux bases du premier et deuxième transistor ($Q_1$, $Q_2$) et dont la base est connectée à l'un des collecteurs desdits premier et deuxième transistor ($Q_1$, $Q_2$), de manière à provoquer le passage des courants de collecteur égaux des premier et deuxième transistor ($Q_1$, $Q_2$);

un quatrième transistor ($Q_4$) dont la base est connectée à l'autre des collecteurs desdits premier et deuxième transistor ($Q_1$, $Q_2$);

une première source de courant constant ($CS_1$)

connectée à l'émetteur dudit quatrième transistor ($Q_4$);

des moyens de commande de courant (DA; CC) ayant une première et une deuxième source de courant respectivement connectées aux collecteurs du premier et du deuxième transistor ($Q_1$, $Q_2$), la différence des courants desdites première et deuxième source de courant étant modifiée en réponse à un signal d'entrée (IN); et

une sortie connectée à la jonction de la première source de courant constant ($CS_1$) à l'émetteur du quatrième transistor ($Q_4$); caractérisé en ce que

le collecteur du quatrième transistor ($Q_4$) est connecté à l'émetteur du troisième transistor ($Q_3$).

3. Circuit amplificateur selon revendication 2, dans lequel lesdites première et deuxième source de courant sont formées avec une paire de transistors ($Q_5$, $Q_6$) dont les bases reçoivent un signal d'entrée différentiel (IN) et dont les collecteurs sont respectivement connectés au premier et deuxième transistor ($Q_1$, $Q_2$), et une deuxième source de courant ($CS_5$) à laquelle les émetteurs de ladite paire de transistors ($Q_5$, $Q_6$) sont connectés.

# Fig. I

# Fig. 2

# Fig. 3